# EUROPEAN PATENT SPECIFICATION

(11) **EP 0 651 507 B1**
(45) Date of publication and mention of the grant of the patent: **13.01.1999**
(21) Application number: 94116913.8
(22) Date of filing: 26.10.1994
(51) Int. Cl.: H03K 17/567, H03K 17/08, H03K 17/56

(54) **Control device for double gate semiconductor device**
Steuervorrichtung für Halbleitervorrichtung mit doppeltem Gate
Dispositif de commande pour dispositif semi-conducteur à double grille

(30) Priority: 28.10.1993 JP 269355/93
(43) Date of publication of application: 03.05.1995
(73) Proprietor: FUJI ELECTRIC CO., LTD., Kawasaki-shi, Kanagawa-ken (JP)
(72) Inventor: Terasawa, Noriho, c/o Fuji Electric Co., Ltd., Kawasaki-shi, Kanagawa (JP)
(74) Representative: Pellmann, Hans-Bernd, Dipl.-Ing.

(56) References cited:
- EP-A- 0 463 325
- EP-A- 0 568 353

## Description

The present invention relates to a semiconductor apparatus.

In particular, the present invention relates to a structure of a control device for semiconductor power devices having two gate voltages, selectable for thyristor operation or transistor operation as IGBT, specifically to a structure of a control device in which, when a first insulated gate electrode goes low and a second insulated gate electrode goes high, the device goes to a turn-off condition to block current from a collector electrode to an emitter electrode or, when the first insulated gate electrode goes high and the second insulated gate electrode goes low, the device allows thyristor operation to conduct the current or, when both the first and the second insulated gate electrodes go high, it allows transistor operation and goes to a turn-off status.

EP-A-0 463 325 discloses a semiconductor device having a bipolar transistor, an insulated gate field effect transistor and a thyristor combined together into a MAGT (MOS assistance gate thyristor). The different operation modes of the semiconductor device are controlled by applying a signal to a base electrode arranged between the two gate electrodes.

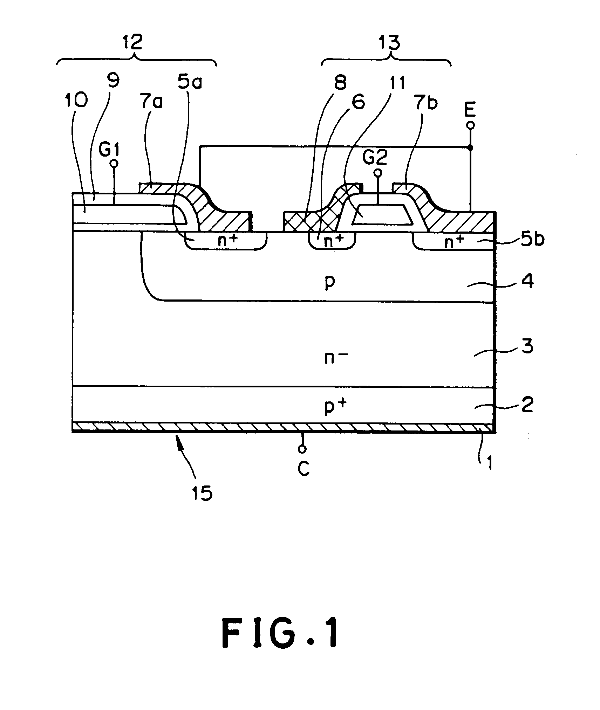

Fig. 1 is a cross sectional illustration of a double gate semiconductor device which is controlled by a control device. This device is disclosed in detail by the same applicant in Japanese Patent Application Laying-open No. 125078/1994 published on May 6, 1994, and the number of the corresponding U.S. Patent Application thereof is 08/218200 filed on March 28, 1994 which is a continuation Application of U.S. Patent Application No. 08/096978 filed July 27, 1993. As shown in the Figure, a double gate semiconductor device 15 comprises a p⁺ type semiconductor substrate as a collector layer 2 provided on the surface with a collector electrode 1, and an n⁻ type base layer 3 epitaxially formed on top of the collector layer 2. A p type well-formed base layer 4 is diffused on the surface of the n⁻ type base layer 3. Further, an n⁺ type well-formed first emitter layer 5a, a second emitter layer 5b, and a drain layer 6, independent of each other, are formed on the inner surface of the p type base layer 4. Of these components, the n⁺ type emitter layers 5a and 5b are connected to each other through emitter electrodes 7a and 7b, and the p type base layer 4 and the n⁺ type drain 6 are connected with a short-circuit electrode 8 extending thereover. From the n⁺ type emitter layer (first emitter layer) 5a to the surface of the p type base layer 4 and the n⁻ type base layer 3, a polycrystalline first gate electrode 10 forming a first MOSFET 12 is provided through a gate oxide film 9. On the other hand, from the n⁺ drain layer 6 to the surface of the p type base layer 4 and the n⁺ emitter layer (second emitter layer) 5b, a polycrystalline second gate electrode 11 forming a second MOSFET 13 is provided through the gate oxide film 9. The first MOSFET 12 formed of the first gate electrode 10 and the second MOSFET 13 formed of the second gate electrode 11 are both n channel type MOSFETs.

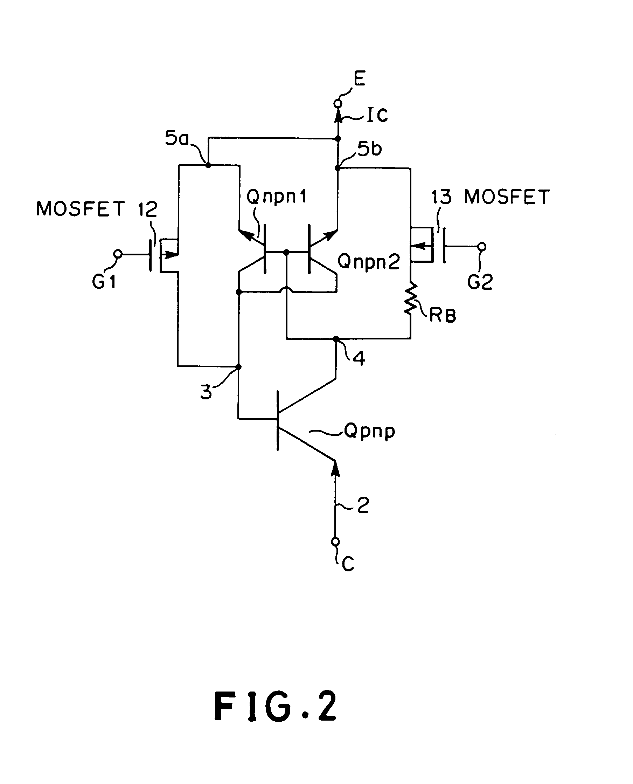

Fig. 2 is an equivalent circuit diagram of the double gate semiconductor device shown in Fig. 1. As shown, an npn type transistor Qnpn 1 is formed of the n⁺ type first emitter layer 5a, the p type base layer 4, and the n⁻ type base layer 3, and an npn type transistor Qnpn 2 is formed of the n⁺ type second emitter layer 5b, the p type base layer 4, and the n⁻ type base layer 3. Further, a pnp type transistor Qpnp is formed of the p type base layer 4, the n⁻ type base layer 3, and the p⁺ type collector layer 2. Therefore, a thyristor structure is formed of the parallel connected transistors Qnpn 1, Qnpn 2, and Qpnp with separate emitter layers. To these transistors Qnpn 1, Qnpn 2, and Qpnp, the first MOSFET 12 serves for a function to connect the n⁻ type base layer 3 as the collector of the transistor Qnpn 1 with the first emitter layer 5a to inject electrons to the n type base layer 3 through the p type base layer 4. Further, the second MOSFET 13 serves for a function to connect the drain layer 6 and the second emitter layer 5b to accept positive holes from the base layer 4.

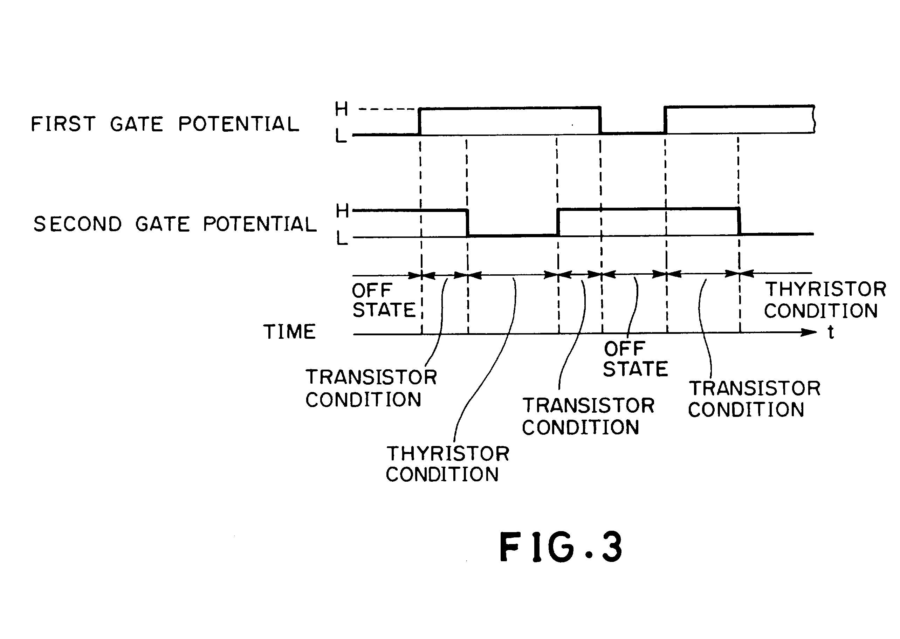

Fig. 3 is a timing chart showing an ON/OFF control method of the double gate semiconductor device shown in Fig. 1. As shown, when the first insulated gate electrode 10 is maintained at a zero potential (L level) and the second insulated gate electrode 11 at a high potential (H level), a double gate semiconductor 15 goes to a turn-off condition, where the transistors Qnpn 1, Qnpn 2, and Qpnp are all non-conductive to block current from the collector electrode 1 to the emitter electrodes 7a and 7b. As a control method to turn on the double gate semiconductor device 15 in the turn-off condition, first, when a high potential is applied to the first insulated gate electrode 10, a transistor condition is achieved where only the transistor Qpnp becomes conductive and, with this condition, when a zero potential is applied to the second insulated gate electrode 11, a thyristor condition is achieved where all of the transistors Qnpn 1, Qnpn 2, and Qpnp are conductive, and a current Ic is passed through to provide a low turn-on resistance of less than 1V. Then, to turn off the double gate semiconductor device 15, first, a high potential is applied to the second insulated gate electrode 11 to set the transistor condition where the transistors Qnpn 1 and Qnpn 2 are non-conductive and, with this condition, a low potential is applied to the first insulated gate electrode 10 to make the transistor Qpnp non-conductive, thereby setting the double gate semiconductor device 15 in the turn-off condition and block the current Ic.

Turn-off control of the double gate semiconductor device 15 of the above construction is similar to that of a prior art double gate semiconductor device (not shown) wherein the transistor condition is achieved as a stand-by condition, however, whereas the first insulated gate electrode 10 sets a turn-on signal at a rising edge of the gate signal and a turn-off signal at a falling edge to achieve ON/OFF control, the second insulated gate electrode 11 must make a transition control from the thyristor operation to the transistor operation using the falling edge of the gate signal as a turn-on (transition) signal from the transistor condition to the thyristor condition, and the rising edge as a turn-off (transition) signal from the thyristor operation to the transistor operation. Thus, the ON/OFF control method differs from that of the prior art semiconductor device in that the voltage application modes of the two gate electrode potentials are reverse to each other. Therefore, a control device to control the double gate semiconductor device 15 is required to be able to produce two control signals with operation modes reverse to each other from a signal input gate signal (input signal) while maintaining the mutual timing, which are supplied to the first and second insulated gate electrodes. In particular, since, unless the two control signals are appropriately controlled, transfer from the thyristor condition to the transistor condition is not positively achieved, resulting in an unstable turn-off operation, when the double gate semiconductor device is used as a switching device in an inverter, this results in an arm short-circuit, leading to a major accident.

Further, the double gate semiconductor device cannot make turn-off control of the current via the transistor condition, and must be transferred first to the transistor condition when a trouble occurs immediately after turning on, difficult to be immediately shut off, and is thus required to have a protective function for early detection of a trouble during operation. In particular, the double gate semiconductor device 15 has a property that it is not allowed to achieve the turn-off condition, when the first insulated gate electrode is set to a low potential, that is, an L level voltage lower than the gate ON threshold level, the thyristor condition when the first insulated gate electrode is set to a high potential and the second insulated gate electrode to a low potential, the transistor condition when both the first insulated gate electrode and the second insulated gate electrode are set to a high potential, the first insulated gate electrode and the second insulated gate electrode not allowed both to go to a low potential, and it is destroyed when an operating voltage is applied across the collector and the emitter with the first insulated gate electrode and the second insulated electrode both at a low potential, and it is required to find such an abnormal condition at an early time to effect a protective operation.

Further, EP-A-0 568 353 published on 03.11.93, being cited pursuant to Art. 54(3) and (4) EPC discloses a control device for a double gate semiconductor device. This control device comprises a first gate control circuit and a second gate control circuit. However, the signals output from the two control circuits and applied to the two gates generally have the same potential.

It is an object of the present invention to provide a semiconductor apparatus controlled by a control device which allows a pair of gate electrodes having voltage application modes reverse to each other to be operable by a single input signal.

According to the invention this object is accomplished by a semiconductor apparatus as defined in claim 1.

Advantageous embodiments are defined in the subclaims.

With the control device, which comprises first insulated gate electrode control means for supplying a turn-off signal of an input signal to the first insulated gate electrode, and second insulated gate electrode control means for reversing the input signal and applying the reversed signal to the second insulated gate electrode, the following effect is obtained. First, with no input signal, the first insulated gate electrode control means sets the first insulated gate electrode to a low potential, and the second insulated gate electrode control means sets the second insulated gate electrode to a high potential. Further, at a rising edge of the input signal, the first insulated gate electrode goes to a high potential, and the second insulated gate electrode goes to a low potential for transition to the thyristor condition. At a falling edge of the input signal, the first insulated gate electrode remains at the high potential by the delaying function of the first insulated gate electrode control means, and the second insulated gate electrode changes to the high potential for transition to the transistor condition. At the end of the delaying function of the first insulated gate electrode control means, the first insulated gate electrode goes to the low potential to obtain a function to block the passing current. As a result, since the double gate semiconductor device with voltage application modes of the pair of gate electrodes reverse to each other can be controlled by a single input signal, a single control signal is sufficient to control an external device using the double gate semiconductor device such as a switching power supply device as in the case of using a prior art single gate semiconductor device.

Further, when timer delay means for delaying the falling edge of the input signal (turn-off signal) for a predetermined time is used as the first insulated gate electrode control means, a function to maintain the transistor condition for a period corresponding to the delay time to assure the turn-off operation is obtained. Therefore, by using an input signal reversing inverter and an even number of waveform shaping inverters connected in series to the inverter to form the second insulated gate electrode control means, a function to reverse and shape the input signal is obtained to assure transition to the thyristor condition and the transistor condition, and to produce a gate voltage adapted to the pair of gate electrodes reverse in operation mode to each other.
Further, when the first insulated gate electrode control means is formed of operation determination delay means, since transition from the thyristor condition to the transistor condition can be determined from a change in the operating voltage to apply the turn-off signal to the first insulated gate electrode, the double gate semiconductor device can be positively controlled from the transistor condition to the turn-off condition.

Further, when the above control device is provided with abnormality detection and protective means comprising passing current determination circuit and turn-off signal applying circuit, if an overcurrent flows during operation of the double gate semiconductor device, it is detected by the passing current determination circuit, a turn-off signal is applied to the first and second insulated gate electrodes through the turn-off signal applying circuit to set the double gate semiconductor device to the turn-off condition, and a function to avoid an abnormal condition and to protect the semiconductor device from being damaged can be obtained.

When the control device is formed of the first insulated gate electrode control means for delaying the turn-off of the input signal and supplying the signal to the first insulated gate electrode, and the second insulated gate electrode control means for delaying the input signal and reversing its potential and applying the potential to the second insulated gate electrode, a function to positively and flexibly select the ON/OFF control of the double gate semiconductor, device starting from the transistor condition is obtained, such that the falling edge of the second insulated gate electrode potential, during the delaying period, the first insulating gate electrode potential rises to transfer the double gate semiconductor device from the OFF state to the transistor condition and, after the delaying period, the second insulated gate electrode potential falls to transfer the double gate semiconductor device to the thyristor condition.

Further, when the second insulated gate electrode control means is provided with a current determination circuit capable of determining an abnormality of the passing current value, and the turn-off signal applying circuit for applying an OFF signal to the first insulated gate electrode according to the abnormality determination result, a function to prevent damages to the semiconductor device due to an overcurrent is obtained, since it is possible that the current determination circuit detects an overcurrent in the transistor condition, the turn-off signal applying circuit applies the turn-off signal to the first insulated gate electrode to immediately turn off the double gate semiconductor device.

Further, when the double gate semiconductor device is a sense double gate semiconductor device with a sense terminal, by connecting a current determination circuit capable of determining an abnormality of the passing current to the sense terminal, a function to reduce the current in the detection resistor of the current determination circuit and to facilitate the detection is obtained. Moreover, a similar function can be obtained by replacing the current determination circuit with a voltage determination circuit capable of determining an abnormality of the operating voltage applied to the collector electrode of the double gate semiconductor device. Further, when the second insulated gate electrode control means is provided with abnormality detection means comprising a passing current determination circuit capable of determining an abnormality of the passing current value, a turn-on signal applying circuit for applying a delayed turn-on signal to the second insulated gate electrode through the reversing inverter according to the abnormality determination result of the passing current determination circuit, and a turn-off signal applying circuit for applying a turn-off signal to the first insulated gate electrode control means according to the abnormality determination result of the passing current determination circuit, a protective function can be obtained which, even when an abnormality occurs in either the transistor condition or the thyristor condition, a turn-on signal is immediately applied from the turn-on signal applying circuit to the second insulated gate electrode to set the double gate semiconductor device to the transistor condition, thereby enabling safe turn-off operation.

Next, when the control device having the first insulated gate electrode control means having timer delay means, and the second insulated gate electrode control means having timer delay means and a reversing inverter, is provided with abnormality detection and protective means comprising a timer circuit for detecting a rising edge of the operating current to operate for a predetermined time, an abnormality notify circuit for monitoring the first insulated gate electrode potential and the second insulated gate electrode potential during operation of the timer circuit and, when the gate electrode potentials are both low, giving a low-potential notify signal, and a turn-off signal applying circuit for applying a turn-off signal to the first and second insulated gate electrode control means in response to the notify signal, the abnormality notify circuit monitors the first and seond insulated gate electrode potentials for the period when the timer circuit operates for a predetermined time and interrupts the application of the operating voltage to the collector, when the gate electrode potentials are both low, a low-potential notify signal is given, and the turn-off signal applying circuit operates in response to the low-potential notify signal to apply a turn-off signal to the first insulated gate electrode control means and the second insulated gate electrode control means, thereby maintaining the double gate semiconductor device in the OFF state. Therefore, when an external device receiving the notify signal is adapted to discontinue supply of the operating voltage to the collector electrode, application of the operating voltage across the collector and the emitter can be prevented in the condition where both the first and second insulated gate electrodes are at a low potential, thereby preventing occurrence of latch-up in the double gate semiconductor device and damages due to the latch-up.

The above and other objects, effects, features and advantages of the present invention will become more apparent from the following description of embodiments thereof taken in conjunction with the accompanying drawings.
Fig. 1 is a schematic illustration showing the structure of the double gate semiconductor device to be controlled by the present invention;
Fig. 2 is an equivalent circuit diagram showing the double gate semiconductor device shown in Fig. 1;
Fig. 3 is a timing chart illustrating an ON/OFF control method of the double gate semiconductor device shown in Fig. 1;
Fig. 4 is a simplified circuit diagram showing the control device for the double gate semiconductor device according to an embodiment 1 of the present invention;
Fig. 5 is a timing chart illustrating the operation of the control device shown in Fig. 4;
Fig. 6 is a simplified circuit diagram showing a control device for the double gate semiconductor device according to an embodiment 2 of the present invention;
Fig. 7 is a circuit diagram showing the structure of a control device for the double gate semiconductor device according to an embodiment 3 of the present invention;
Fig. 8 is a timing chart illustrating the protective operation of the control device shown in Fig. 3;
Fig. 9 is a simplified circuit diagram showing a control device for the double gate semiconductor device according to an embodiment 4 of the present invention;
Fig. 10 is a timing chart illustrating the operation of the control device of the embodiment 4 in a normal starting condition;
Fig. 11 is a timing chart showing the operation of the control device of the embodiment 4 in an abnormal starting condition;
Fig. 12 is a simplified circuit diagram showing a control device for the double gate semiconductor device according to the embodiment 3 of the present invention;
Fig. 13 is a simplified circuit diagram showing the structure of a control device according to the embodiment 4 of the present invention;
Fig. 14 is a circuit diagram showing the structure of a control device for the double gate semiconductor device according to an embodiment 5 of the present invention;
Fig. 15 is a timing chart illustrating changes in gate voltage of the control device of the embodiment 5 in a normal operation;
Fig. 16 is a timing chart illustrating changes in gate voltage of the control device of the embodiment 5 when an overcurrent occurs in the transistor condition;
Fig. 17 is a timing chart illustrating changes in gate voltage of the control device of the embodiment 5 when an overcurrent occurs in the thyristor condition;
Fig. 18 is a simplified circuit diagram showing a control device for the double gate semiconductor device according to an embodiment 6 of the present invention; and
Fig. 19 is a simplified timing chart illustrating the operation of the control device of the embodiment 6 when an abnormality occurs.

### Embodiment 1

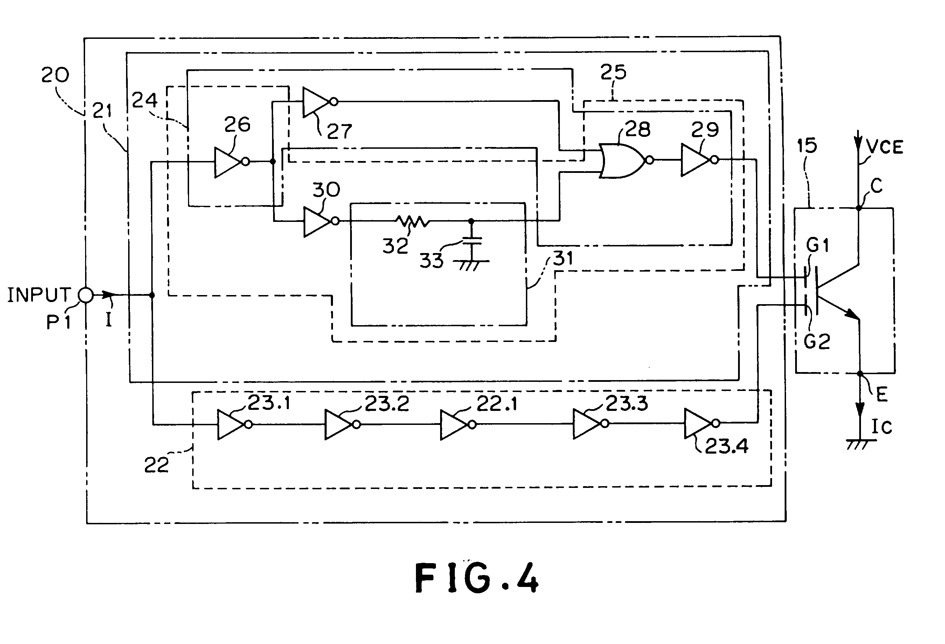

The present invention will be described with reference to the embodiments. Fig. 4 is a simplified circuit diagram showing a control device for the double gate semiconductor device according to an embodiment 1 of the present invention. Similar components are indicated by similar reference symbols, and detailed description thereof is omitted. A control device 20 for driving a double gate semiconductor device 15 comprises first gate electrode control means 21 for controlling a first gate G1 and second gate electrode control means 22 for controlling a second gate G2. The first gate electrode control means 21 comprises a pair of waveform shaping inverters 26 and 27 disposed at an input terminal P1 side of an input signal I, and an ON path comprising a series circuit of a NOR gate 28 and an inverter 29 disposed at the gate G1 side, and an off-delay path 25 comprising an inverter 30 connected between the inverter 26 and the NOR gate 28 and a delay circuit 31 (resistor 32, capacitor 33). Further, the second gate electrode control means 22 comprises a polarity reversing inverter 22.1 connected between the input terminal P1 and the second gate G2, and two pairs of waveform shaping inverters 23.1, 23.2, 23.3, and 23.4 connected in series to both sides of the above reversing inverter.

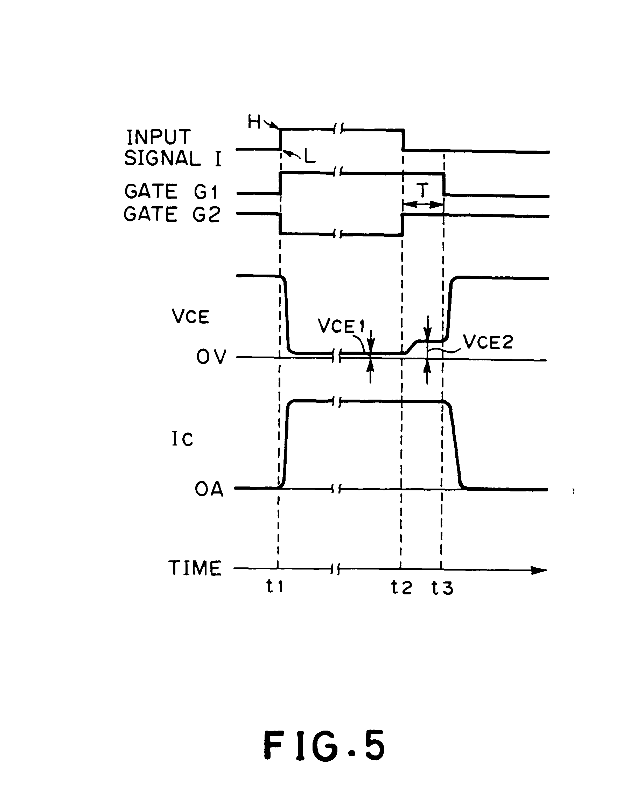

Fig. 5 is a timing chart illustrating the operation of the control device of the embodiment shown in Fig. 4. In the non-operation condition of the double gate semiconductor device 15 where the input signal I is not inputted, the first gate electrode is maintained at a low potential (L level) and the second gate electrode at a high potential (H level). At a point tl where the input signal I rises (turn-on signal), the H level turn-on signal, waveform shaped in the ON path 24, is applied to the first gate electrode to momentarily set the double gate semiconductor device to the transistor condition, then the turn-on signal, reversed by the second gate electrode control means 22 to be the L level, is applied to the second gate electrode to transfer the double gate semiconductor device 15 to the thyristor condition, so that the voltage VCE between the collector and emitter decreases to VCE1 less than 1V to conduct the passing current IC with a reduced loss. At a point t2 where the input signal I falls (turn-off signal), the first gate electrode is continuously maintained at the H level by the H level signal delayed in the off-delay path, so that the potential of the second gate electrode is changed to the H level by the falling edge of the input signal I as a turn-off signal, the double gate semiconductor device transfers to the transistor condition, and VCE increases to VCE2 by the increase in the ON resistance to achieve a stand-by state of OFF operation. Then, at a point t3 where the delay time of the delay circuit 31 is elapsed, an L level turn-off signal is applied to the first gate electrode to block the passing current IC, and the double gate semiconductor device 15 transfers to the OFF state.

With the control device of the embodiment 1, since the first and second gate electrodes having voltage application modes reverse to each other can be controlled by the single input signal I, an advantage of simplifying the structure of an external device as a generation source of the input signal I can be obtained. Further, since the turn-off signal applied to the first gate electrode can be delayed by the delay circuit provided in the first gate electrode control means to set the double gate semiconductor device to the transistor condition for a period corresponding to the delay time, it is possible to make a positive turn-off operation utilizing the transistor condition, thereby preventing damages to the double gate semiconductor device due to mis-operation.

### Embodiment 2

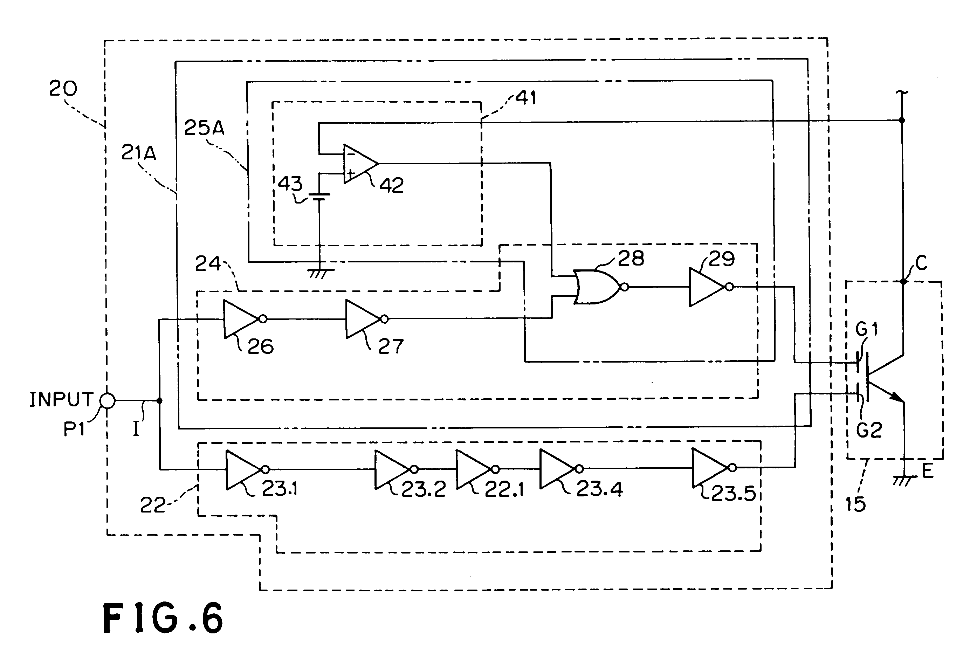

Fig. 6 is a connection diagram showing the simplified structure of the control device according to an embodiment 2 of the present invention. This embodiment differs from the embodiment 1 in that an off-delay path 25A of first gate electrode control means 21A includes a transistor condition determination circuit 41 comprising a comparator 42 and a reference power supply 43 connected to a non-reversing side of the comparator. Therefore, when the reference power supply voltage is set to a value lower than the voltage VCE2 between the collector and emitter in the transistor condition, transition from the thyristor condition to the transistor condition is detected by a voltage increase from VCE1 to VCE2, and one input of the NOR gate 28 changes to the H level. At this moment, since the signal applied from the waveform shaping inverters 26 and 27 of the turn-on path 24 to the NOR gate is already changed to the L level at the rising edge of the input signal I, inputs of the NOR gate are in line with each other, a turn-off signal is applied to the first gate electrode Gl to transfer the double gate semiconductor device 15 to the OFF state through the transistor condition.

Thus, since in the control device of the embodiment 2, after transition from the thyristor condition to the transistor condition is checked by the comparator circuit 41, the turn-off signal is supplied to the first gate electrode to turn off the double gate semiconductor device, an advantage to positively prevent the double gate semiconductor device from being damaged due to a mis-control can be obtained.

### Embodiment 3

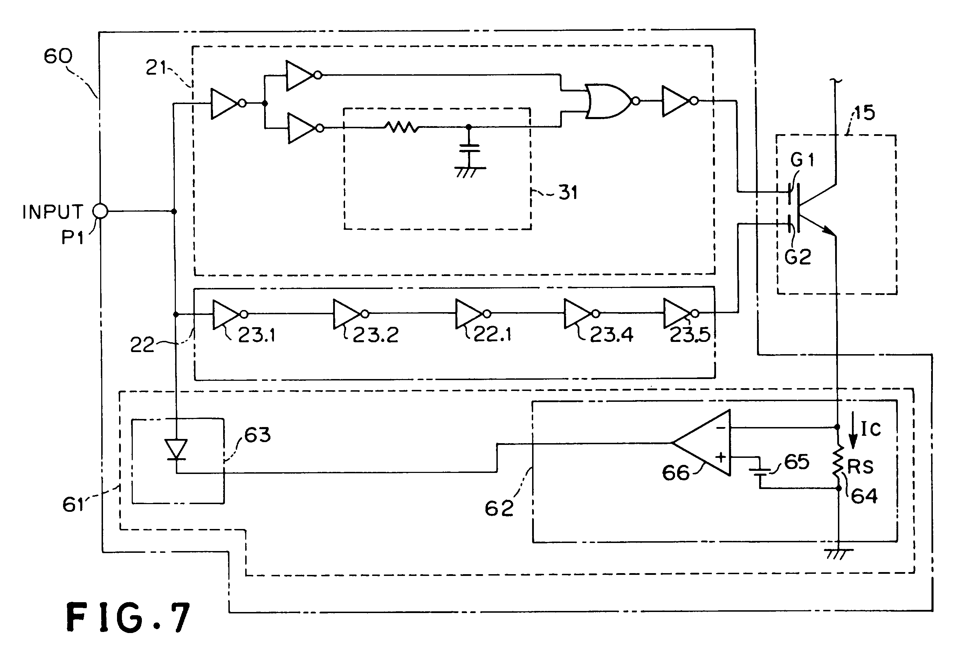

Fig. 7 is a circuit diagram showing the simplified structure of the control device for the double gate semiconductor device according to an embodiment 3 of the present invention. The present embodiment differs from the above embodiments in that a control device 60 including first gate electrode control means 21 having timer delay means 31, and second gate electrode control means having an input signal polarity reversing inverter 22.1 is provided with abnormality detection and protective means 61 comprising a passing current determination circuit 62 capable determining an abnormality of the passing current IC, and a turn-off signal applying circuit 63 for applying a turn-off signal to the first gate electrode control means 21 according to the abnormality determination result of the passing current determination circuit. The passing current determination circuit 62 comprises an IC detection resistor 64 (resistor RS) and a comparator 66 for comparing the voltage drop with the voltage of a reference power supply 65. The turn-off signal applying circuit 63 comprises a diode connected in a forward direction where a direction from the input terminal P1 to the output side of the comparator is referred to the forward direction.

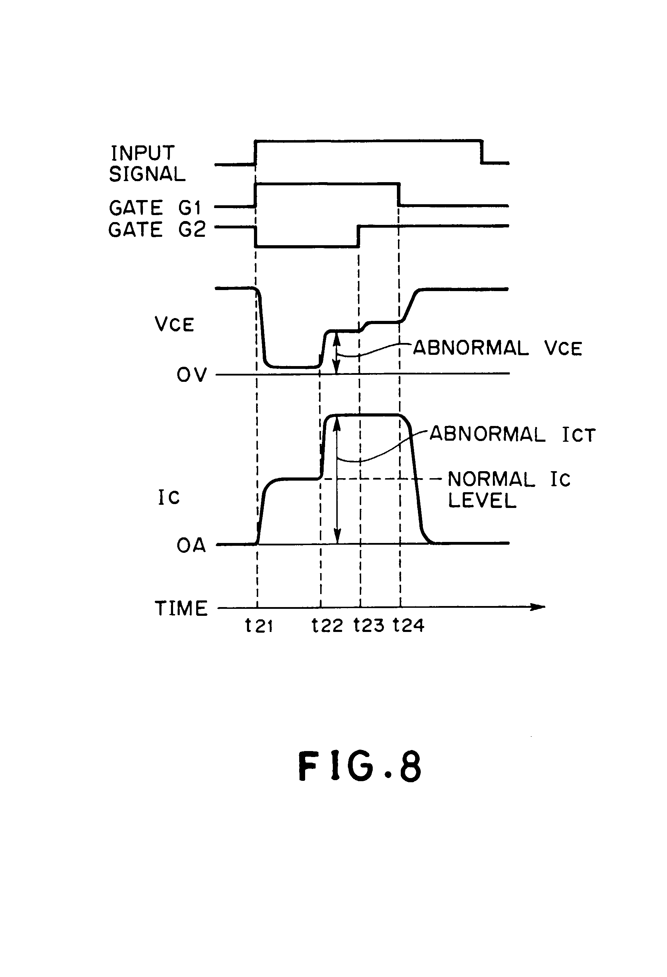

Fig. 8 is a timing chart illustrating the protective operation of the control device of the embodiment 3. When the double gate semiconductor device 15 is set to the thyristor condition at a point t21 by the first gate electrode control means 21 and the second gate electrode control means 22 and, during normal operation, an excessive current ICT occurs, for example, due to a load short-circuit, an arm short-circuit, or the like, output of the comparator 66 of the passing current determination circuit 62 is reversed to be the L level. This change is detected by the turn-off signal applying circuit 63 and the input terminal P1 potential is changed to the L level. As a result, the second gate electrode potential is changed to the H level at a point t23 through the second gate electrode control means 22, the double gate semiconductor device 15 is transferred to the transistor condition, whereby the first gate electrode potential is changed to the L level by a time corresponding to the delay time of the timer delay means 31, and the double gate semiconductor device 15 can be set to the OFF state at a point t24.

In the embodiment 3 of the above construction, since, by adding the abnormality detection and protective means 61 to the control device, blocking of the excessive current can be positively made during the transistor condition and in a time shorter than the duration time of the input signal, the passing time of the excessive current can be reduced, thereby reducing damages to the double gate semiconductor device.

### Embodiment 4

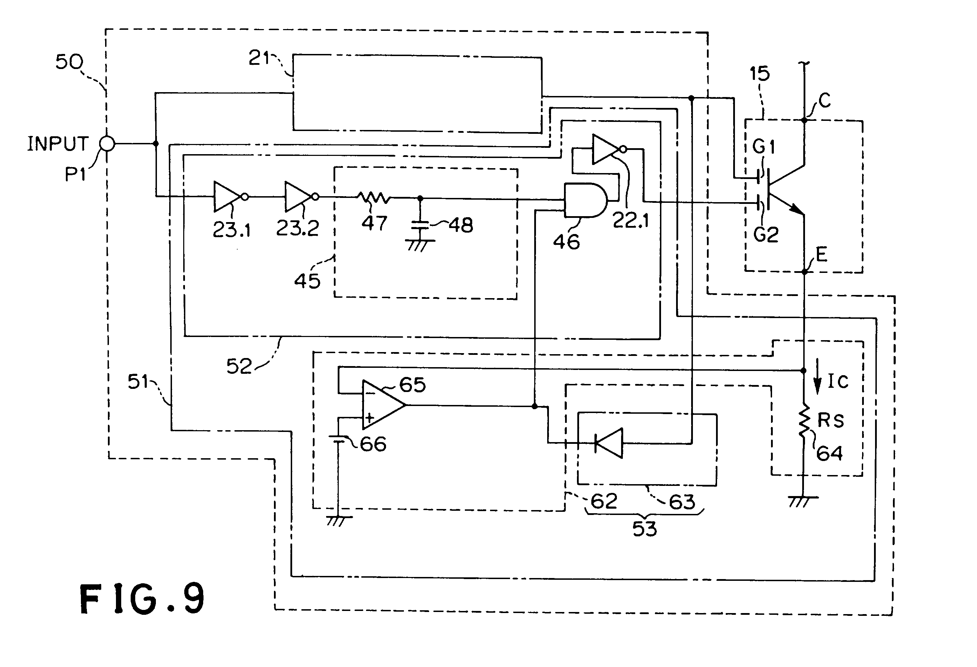

Fig. 9 is a circuit diagram showing the simplified structure of a control device for the double gate semiconductor device according to an embodiment 4 of the present invention. A control device 50 comprises first gate electrode control means formed as in the embodiment 1, and second gate electrode control means 51 for delaying the input signal and reversing the input signal according to the abnormality determination result of the passing current and applying the signal to the second gate electrode G2. That is, the second gate electrode control means 51 comprises a pair of waveform shaping inverters 23.1 and 23.2, a delay circuit 46 comprising a resistor 47 and a capacitor 48, a reversed turn-on signal applying circuit 52 comprising an AND gate 49 and a waveform reversing inverter 22.1, and abnormality detection and protective means 53 comprising a passing current determination circuit 62 capable of determining an abnormality of the passing current IC of the double gate semiconductor device 15, and a turn-off signal applying circuit 63 for outputting a turn-off signal delayed according to the determination result of the current determination circuit 62 to reversed turn-on signal applying circuit 52. The abnormality detection and protective means 53 comprises the passing current determination circuit 62 formed as in the embodiment 3, and the turn-off signal applying circuit 63 comprising a diode connected in a forward direction which is a direction from the first gate electrode G1 side to the output side of the comparator 65. Output signal of the comparator 65 is inputted to the AND gate 49 to check the AND condition with the input signal delayed by the delay circuit 46.

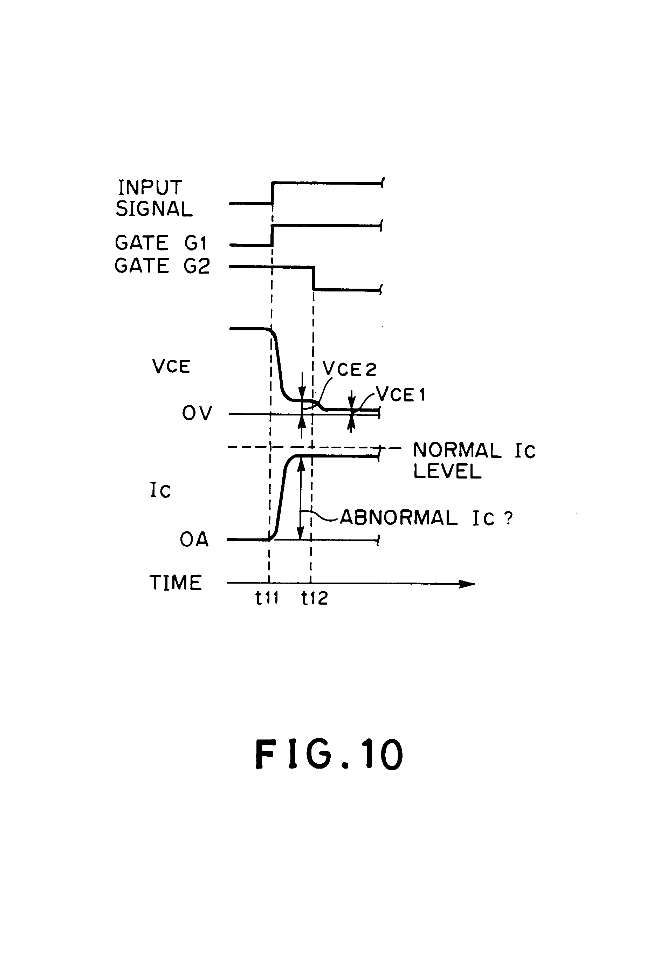

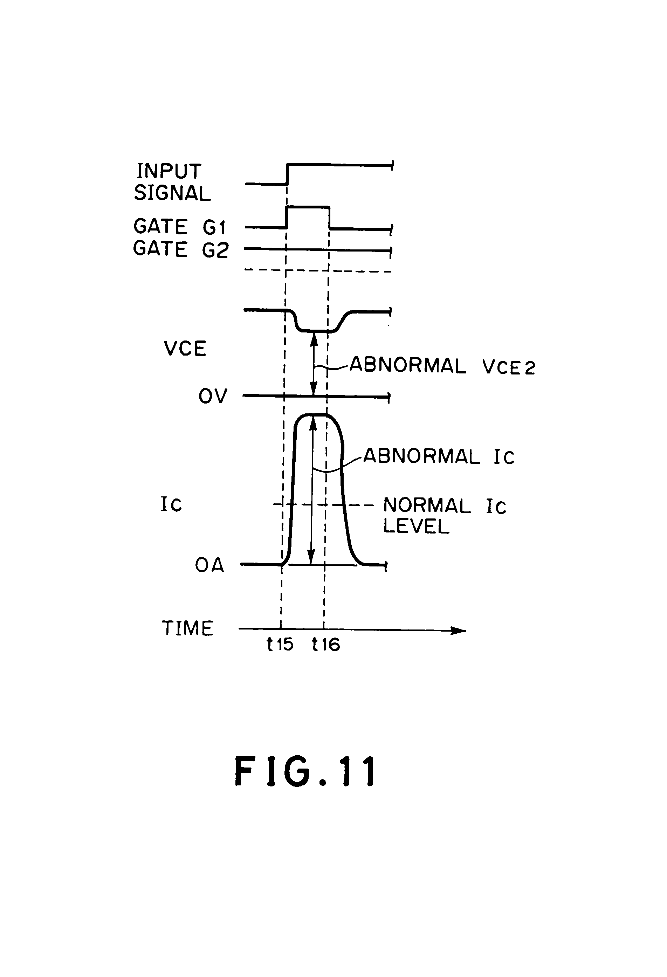

Fig. 10 is a timing chart illustrating the operation of the control device of the embodiment 4 in a normal starting condition, and Fig. 11 is a timing chart illustrating the operation of the control device of the embodiment 4 in an abnormal starting condition. Referring to Fig. 10, when the input signal of the control device 50 changes to the H level at a point tll, an H level turn-on signal is applied to the first gate electrode by the first gate electrode control means. On the other hand, since in the reversed turn-on signal applying circuit 52, a delay occurs in the change to the H level of the input signal by the delay circuit 46, the second gate electrode potential is maintained at the H level in the OFF state. Therefore, the double gate semiconductor device 15 becomes conductive in the transistor condition rather than the thyristor condition to pass the current IC, and the collector - emitter voltage VCE is decreased to VCE2. At this moment, the passing current is compared as a voltage drop of the detection resistor 64 with a reference voltage by the comparator 65 of the passing current determination circuit 62, when the passing current IC is smaller than the normal IC level, the comparator 65 output is not reversed and maintained at the H level, after a delay to a point t12 by the delay circuit 46, and when the input of the AND gate 49 is changed to the H level to meet the AND condition, a signal changed to the L level by the reversing inverter 22.1 is applied to the second gate electrode, and the double gate semiconductor device 15 is transferred from the transistor condition to the thyristor condition.

Further, when an excessive current occurs at a point t15 immediately after the transfer to the transistor condition, this is detected by the passing current determination 62 as shown in Fig. 11, and the comparator 65 output is reversed. Therefore, output of the signal is blocked by the AND gate 49 of the reversed turn-on signal applying circuit 52, the second gate electrode potential is maintained at the H level, and the turn-on signal applying circuit 63 detects the reversing of the output of the comparator 65 to apply an L level turn-off signal to the first gate electrode. Then, the double gate semiconductor device 15 immediately blocks the excessive current IC at a point t16 by the turn-off operation, thereby preventing the excessive current IC from damaging the double gate semiconductor device.

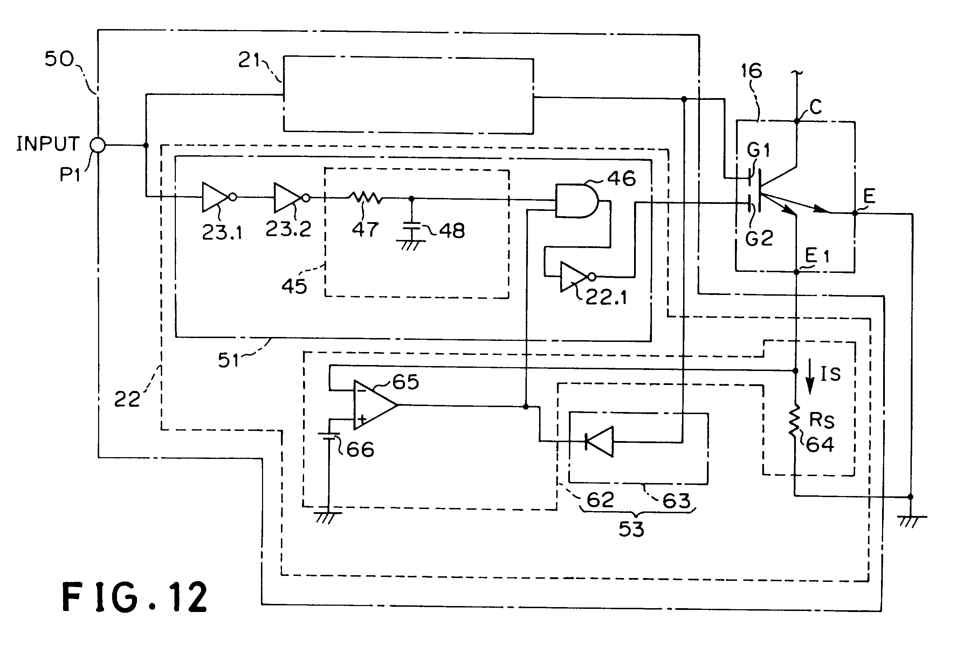

Fig. 12 is a simplified circuit diagram showing the structure of a modification example of the control device for the double gate semiconductor device according to the embodiment 4 of the present invention. This example is directed to control a sense double gate semiconductor device 16 with a sense terminal E1, in which a detection resistor 64 of the abnormality detection and protective means 53 of the control device 50 is connected to the sense terminal E1 to monitor the occurrence of an excessive current and, utilizing the small current in the sense terminal, an advantage is obtained that the current capacity of the detection resistor 64 and power loss generated in the detection resistor 64 can be reduced.

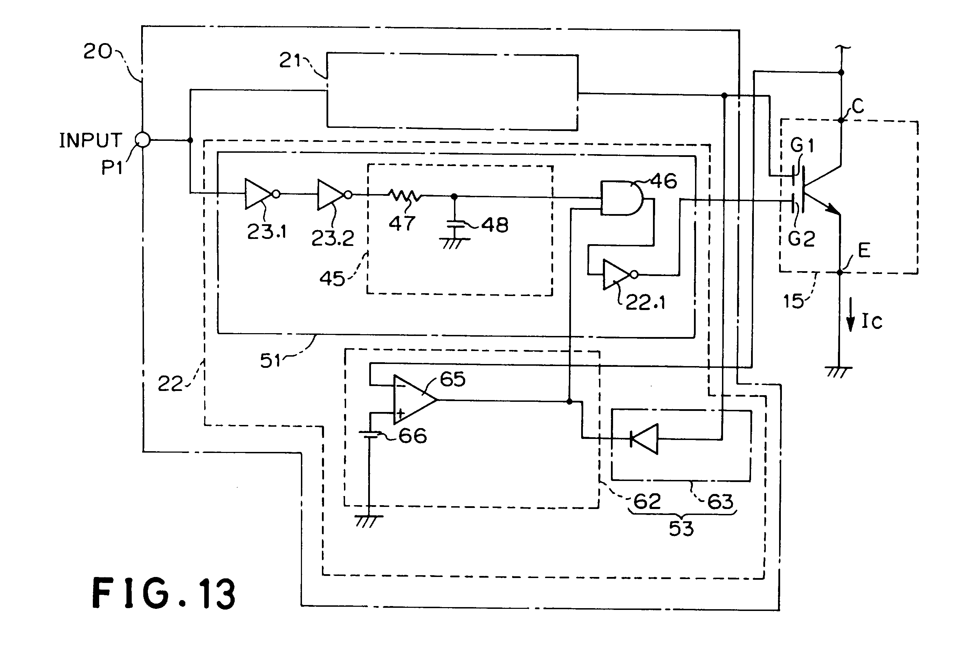

Fig. 13 is a simplified circuit diagram showing the structure of a different modification example of the control device for the double gate semiconductor device according to the embodiment 4 of the present invention. This example differs from the above embodiments in that the reversed input side of the comparator 65 of the passing current determination circuit 62 is connected to the collector terminal of the double gate semiconductor device 15, in which an increase in the collector - emitter voltage VCE2 generated due to an excessive current (Fig. 11) is compared with the reference voltage by the comparator 65, whereby obtaining a function to block an abnormal current in a short time through the transistor condition. In particular, since, in case of a load short-circuit or arm short-circuit, VCE2 increases near to the operating voltage VCE, an overcurrent is accurately detected, and the detection resistor 64 can be eliminated, thereby removing its power loss.

### Embodiment 5

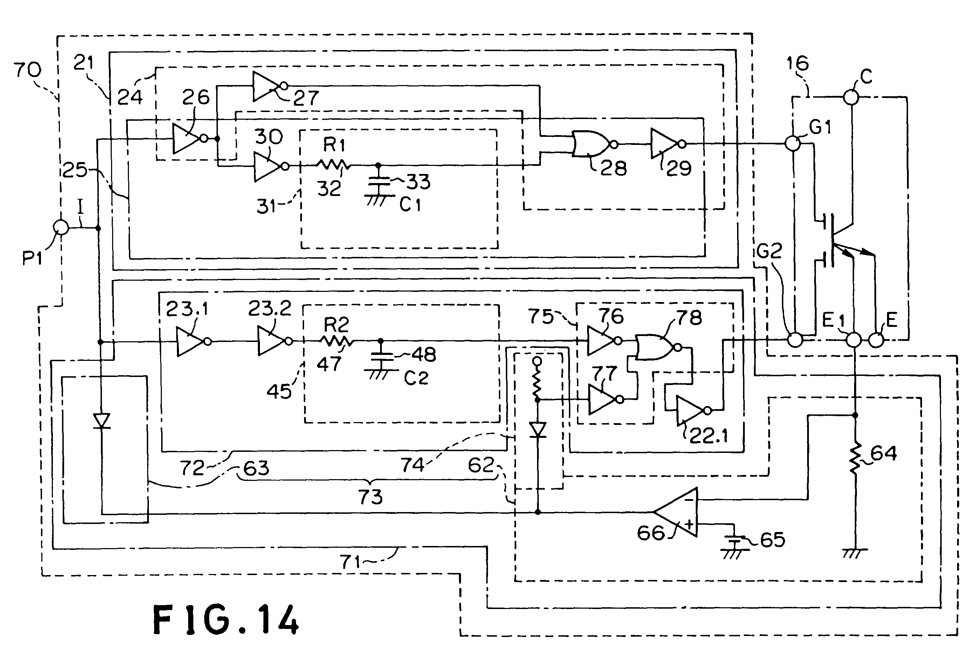

Fig. 14 is a circuit diagram showing a control device for the double gate semiconductor device according to an embodiment 5 of the present invention, in which a sense double gate semiconductor device with the sense terminal El. Referring to the Figure, a control device 70 comprises first gate electrode control means 21 constructed as in the embodiment 1, and second gate electrode control means 71 for reversing the polarity of an input signal and applying the signal to the second gate electrode according to the abnormality determination result of the passing current value. That is, the second gate electrode control means 71 comprises a delay circuit 45 comprising a resistor 47 and a capacitor 48, and abnormality detection and protective means 73 comprising an AND gate 75 comprising inverters 76 and 77 and a NOR gate 78, a passing current determination circuit 52 capable of determining an abnormality of the passing current IC of the double gate semiconductor device 16, a turn-off signal applying circuit 63 for outputting an L level turn-off signal to the input terminal P1 according to the determination result of an overcurrent of the current determination circuit 62, and a turn-off signal applying circuit 74 for outputting an L level turn-off signal to the inverter 77 of the reversed turn-on signal applying circuit 72, wherein the delay time of the delay circuits 31 and 45 are set to satisfy the condition T31>T45.

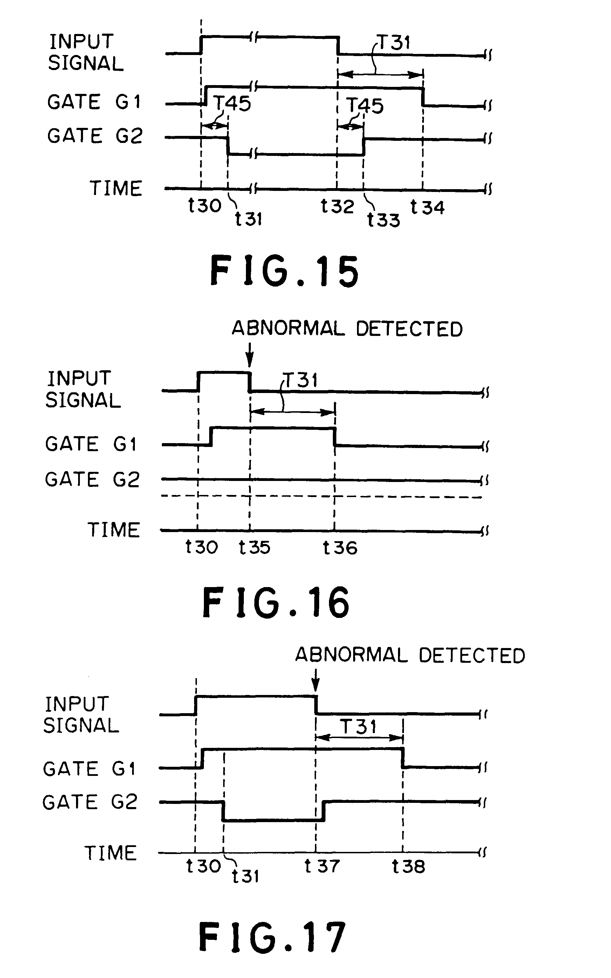

Fig. 15 is a timing chart illustrating changes in gate voltage of the control device of the embodiment 5 in normal operation. When the input signal 1 changes to the H level at a point t30, the first gate electrode potential goes to the H level through the first gate electrode control means 21, and the double gate semiconductor device 16 is transferred from the OFF state to the transistor condition. Then, at a point t31 delayed by the delay time T45 of the on-delay circuit 45 of the reversed turn-on signal applying circuit 72, the H level signal passes through the AND gate 75, converted to an L level signal by the reversing inverter and applied to the second gate electrode, and the double gate semiconductor device 16 is transferred to the thyristor condition. On the other hand, when the input signal changes to the L level at a point t32, at a point t33 delayed by the time T45 the second gate electrode potential goes to the L level, the double gate semiconductor device 16 is transferred to the transistor condition and, at a point t34 delayed by the time T31 from the point t32, the first gate electrode potential goes to the L level, and the double gate semiconductor device 16 is transferred to the OFF state. Therefore, by setting the delay time of the delay circuits 31 and 45 to satisfy the condition T31>T45, the double gate semiconductor device 16 can be transferred to the OFF state through the transistor condition, thereby positively blocking the passing current IC.

Fig. 16 is a timing chart illustrating changes in gate voltage when an overcurrent occurs in the transistor condition. It is assumed that the input signal 1 changes to the H level at a point t30, and an overcurrent generates at a point t35 at which the double gate semiconductor device 16 is transferred from the OFF state to the transistor condition. At this moment, the overcurrent is detected by the passing current detection circuit 62, and an L level turn-off signal is applied to the input terminal P1 and the inverter 77 by the turn-off signal applying circuits 63 and 74. When the input of the inverter 77 changes to the L level, the gate signal, which is reversed three times by the inverter 77, the NOR gate 78, and the reversing inverter 22.1 to be the H level, is applied to the second gate electrode and, by the L level signal, which reaches the inverter 76 with a delay of T45, the second gate electrode is continuously maintained at the H level. On the other hand, the L level turn-off signal applied to the input terminal P1 by the turn-off signal applying circuit 63 is applied to the first gate electrode at a point t36 delayed by the time T31 by the off-delay path 25 of the first gate electrode control means 21, thereby transferring the double gate semiconductor device 16 from the transistor condition to the OFF state.

Fig. 17 is a timing chart illustrating changes in gate voltage when an overcurrent generates in the thyristor condition. It is assumed that at the point t30, the input signal 1 changes to the H level and the double gate semiconductor device 16 is transferred from the OFF state to the transistor condition, and an overcurrent generates at a point t37 after the transfer to the thyristor condition at a point t31. At this moment, the overcurrent is detected by the passing current detection circuit 62, and an L level turn-off signal is applied to the input terminal P1 and the inverter 77 by the turn-off signal applying circuits 63 and 74. When the input of the inverter 77 changes to the L level, the gate signal, which is reversed three times by the inverter 77, the NOR gate 78, and the reversing inverter 22.1 to be the H level, is applied to the second gate electrode, and the double gate semiconductor device 16 is transferred from the thyristor condition to the transistor condition. On the other hand, the L level turn-off signal applied to the input terminal P1 by the turn-off signal applying circuit 63 is applied to the first gate electrode at a point t38 delayed by the time T31 by the off-delay path 25 of the first gate electrode control means 21 and, at this moment, the double gate semiconductor device 16 can be transferred from the transistor condition to the OFF state.

In the control device of the embodiment 5 of the above construction, it is possible to control the first gate electrode and the second gate electrode having operation modes reverse to each other by a single input signal to make ON/OFF control of the double gate semiconductor device, an overcurrent is detected by the abnormality detection and protective means 53, and the double gate semiconductor device can be safely transferred to the OFF state through the transistor condition even when an overcurrent occurs in either the transistor condition or the thyristor condition.

### Embodiment 6

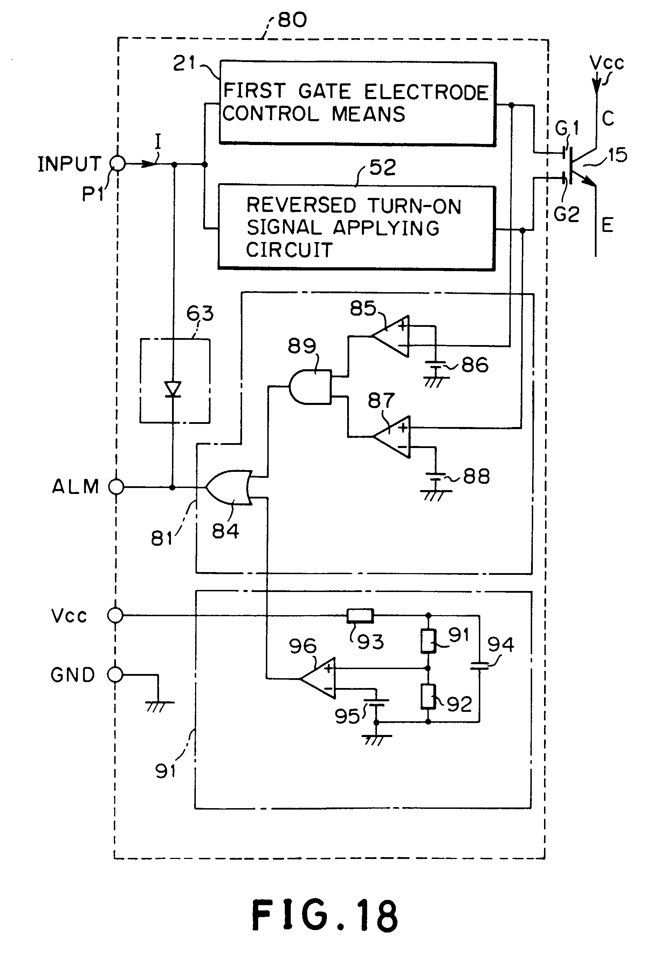

Fig. 18 is a simplified circuit diagram showing the structure of a control device according to an embodiment 6 of the present invention, in which the first and second gate electrode potentials are both L level at the beginning of application of the operating voltage VCC of the double gate semiconductor device 15 or when momentary interruption of the operating voltage is eliminated, thereby preventing latch-up of the double gate semiconductor device. Referring to the Figure, a control device 80 includes first gate electrode control means as shown in the embodiment 4 (Fig. 9) of the present invention and a reversed turn-on signal applying circuit 52 of second gate electrode control means 51, and provided further with a constant time operating timer circuit 91 for detecting a rising edge of the operating voltage applied to the collector electrode of the double gate semiconductor device and operating for a predetermined time, an abnormality notify circuit 81 for monitoring and first gate electrode potential and the second gate electrode potential during operation of the constant time operating timer circuit 91 and outputting a low-potential notify signal when both the gate potentials are low, and a turn-off signal applying circuit 63 for applying a turn-off signal to the first gate electrode control means and the second gate electrode control means in response to the notify signal.

The constant time operating timer circuit 91 is constructed so that the rising edge of the operating voltage VCC is delayed by a constant time by the capacitor 94, the delayed voltage is divided by voltage dividing resistors 91 and 92 and applied to the non-reversed input of the comparator 96 to be compared with the reference voltage of the reference power supply 95, and an H level turn-on signal is outputted when the non-reversed input exceeds the reference voltage. Further, the abnormality notify circuit 81 comprises a comparator 85 for receiving the first gate electrode potential to the non-reversed input side and comparing it with the voltage of a reference power supply 86, a comparator for receiving the second gate electrode potential to the non-reversed input side and comparing it with the voltage of the reference power supply 86, an AND gate 89 disposed at the output side of both the comparators, and an OR gate 84 disposed at the output side of the AND gate 89 and the comparator 96. When the double gate semiconductor device is not in the OFF state where the first gate electrode potential is L and the second gate electrode potential is H during operation of the constant time operating timer circuit 91, the OR gate outputs an L level notify signal. Therefore, when an external device is driven utilizing the notify signal so that the operating voltage VCC is not applied to the double gate semiconductor device 15, latch-up of the double gate semiconductor device 15 caused by applying the operating voltage between the collector and the emitter in the condition where both the first and second gate electrode potentials are L level can be prevented, thereby preventing damages to the double gate semiconductor device due to the latch-up. Further, the notify signal can be detected by the turn-off signal applying circuit 63 to output a turn-off signal to the first gate electrode control means 21 and the reversed turn-on signal applying circuit 52, so that the gate control circuits 21 and 51 do not operated even if an input signal is inputted by mistake.

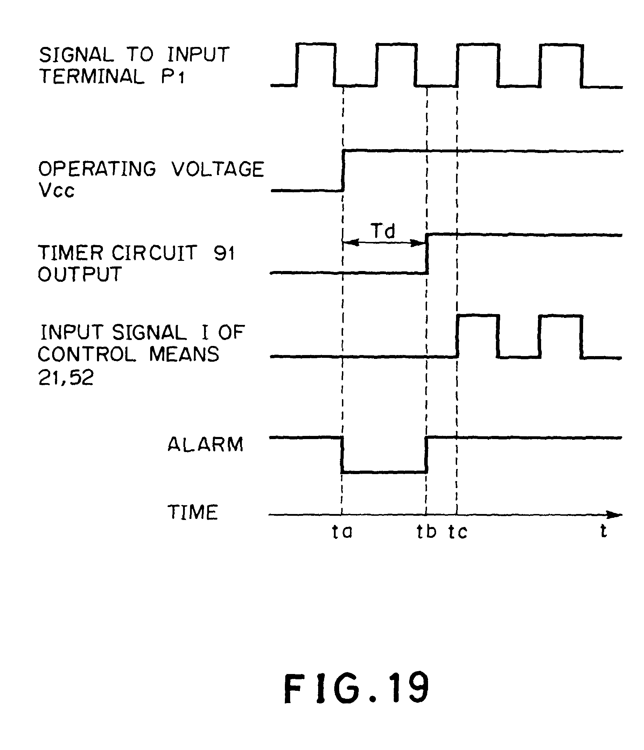

Fig. 19 is a simplified timing chart illustrating the operation of a control device according to an embodiment 6 when an abnormality occurs. It is assumed that the operating voltage VCC rises at a point tc under the condition that the input signal I is applied to the input terminal P1 of the control device 80. At this moment, the constant time operating timer circuit 91 outputs a signal, which rises at a point tb after making a delay operation for a constant time (Td), to the OR gate 84. On the other hand, the abnormality notify circuit 81 monitors whether or not the first and second gate electrode potentials are in the OFF state during a time t, for example, when both are L level, the output side of the OR gate goes to the L level to output an L level notify signal for a time Td. Further, the turn-off signal applying circuit 63 detects the notify signal to output a turn-off signal to the first gate electrode control means 21 and the reversed turn-on signal applying circuit 52 to interrupt the operation of the circuit until the time tb at which the L level notify signal tb. Therefore, by blocking the application of the operating voltage to the double gate semiconductor device by the time tb utilizing the notify signal, damages to the double gate semiconductor device can be prevented.

As described above, the present invention has the second gate electrode capable of controlling the transition to the thyristor condition and the transistor condition, and the first gate electrode capable of controlling the transition from the transistor condition to the thyristor condition, wherein the control device for controlling the double gate semiconductor device having voltage application modes of both gate electrodes reverse to each other comprises the first gate electrode control means for delaying the turn-on signal of the input signal and supplying the signal to the first gate electrode, and the second gate electrode control means for reversing the polarity of the input signal and applying the signal to the second gate electrode. As a result, it is possible to apply ON/OFF signals having voltage application modes reverse to each other to the two gate electrodes by a single input signal, extend the duration time of the voltage applied to the first gate electrode to the wave end, so that the double gate semiconductor device makes the OFF operation always through the transistor condition, thereby providing a control device which can stably make ON/OFF control of the double gate semiconductor device having a pair of gate electrodes having voltage application modes reverse to each other by a single input signal.

Further, by an improvement such as providing a delay circuit or an abnormality detection and protective circuit for an overcurrent or a notify circuit to the second gate electrode control means, a double gate semiconductor device provided with a reliable control device with improved abnormality detection function and protective function can be provided.

The present invention has been described in detail with respect to preferred embodiments, and it will now be that changes and modifications may be made without departing from the invention in its broader aspects, and it is the invention, therefore, in the appended claims to cover all such changes and modifications.

## Claims

1. A semiconductor apparatus comprising:
a double gate semiconductor device (15) having a first insulated gate electrode (G1) capable of controlling transition from a transistor condition to an ON/OFF operation and a second insulated gate electrode (G2) capable of controlling transition to a thyristor condition and the transistor condition, said first and second insulated gate electrodes (G1, G2) having voltage application modes reverse to each other; and
a control device (20; 50; 60; 70; 80) for controlling said double gate semiconductor device (15) according to a single input signal; said control device (20; 50; 60; 70; 80) comprising:
first insulated gate electrode control means (21; 21A) for delaying a turn-off signal of said input signal (I) and supplying the delayed signal to said first insulated gate electrode (G1); and
second insulated gate electrode control means (22; 51; 71) for reversing said input signal (I) and supplying the reversed signal to said second insulated gate electrode (G2).

2. The semiconductor apparatus according to claim 1, wherein
said first insulated gate control means (21) comprise timer delay means (31) for delaying a turn-off signal of said input signal (I) for a predetermined time and applying the signal to said first insulated gate electrode (G1); and
said second insulated gate electrode control means (22) comprise a reversing inverter (22.1) for said input signal (I) and an even number of waveform shaping inverters (23.1, 23.2, 23.3, 23.4) connected in series to said inverter (22.1).

3. The semiconductor apparatus according to claim 1, wherein
said first insulated gate control means (21A) comprise operation determination delaying means (25A) comprising an operation determination circuit (41) for determining an operation voltage applied to a collector electrode (C) of said double gate semiconductor device (15), and a turn-off signal applying circuit (24) for applying a turn-off signal to said first insulated gate electrode (G1) according to the determination result of said operation determination circuit (41); and
said second insulated gate electrode control means (22) comprise a reversing inverter (22.1) of the input signal (I) and an even number of waveform shaping inverters (23.1, 23.2, 23.3, 23.4) connected in series to said reversing inverter (22.1).

4. The semiconductor apparatus according to claim 1, wherein
said first insulated gate electrode control means (21) comprise timer delay means (31) for delaying a turn-off signal of said input signal (I) for a predetermined period of time and applying the signal to said first insulated gate electrode (G1);
said second insulated gate electrode control means (22) comprise a reversing inverter (22.1) of said input signal (I) and an even number of waveform shaping inverters (23.1, 23.2, 23.3, 23.4) connected in series to said reversing inverter (22.1); and
said control device (60) further comprise abnormality detection and protective means (61) comprising a passing current determination circuit (62) capable of determining an abnormality of a passing current value (IC), and a turn-off signal applying circuit (63) for applying a turn-off signal to said first insulated gate electrode control means (21) in response to the abnormality determination result of said passing current determination circuit (62).

5. The semiconductor apparatus according to claim 4, wherein said second insulated gate electrode control means (51) comprise a current determination circuit (62) capable of determining an abnormality of a passing current value (IC), said second insulated gate electrode control means (51) delaying said input signal (I), reversing the potential in response to an abnormality determination result of the passing current value (IC), and applying the potential to said second insulated gate electrode (G2).

6. The semiconductor apparatus according to claim 5, wherein said second insulated gate electrode control means (51) comprise
a reversed turn-on signal applying circuit (52) for outputting a turn-on signal delayed in response to the determination result of said current determination circuit (62), reversing the delayed turn-on signal and applying the turn-on signal to said second insulated gate electrode (G2); and
a turn-off signal applying circuit (63) for applying a turn-off signal to said first insulated gate electrode (G1) according to the abnormality determination result of said current determination circuit (62).

7. The semiconductor apparatus according to claim 6, wherein said double gate semiconductor device (15) is a sense double gate semiconductor device having a sense terminal (El); and
said current determination circuit (52) capable of determining an abnormality of the passing current (IC) is connected to said sense terminal (E1).

8. The semiconductor apparatus according to claim 7, wherein said current determination circuit (62) of said second insulated gate electrode control means (51) is a voltage determination circuit capable of determining an abnormality of the operating voltage applied to a collector electrode (C) of said double gate semiconductor device (15).

9. The semiconductor apparatus according to claim 5, wherein said second insulated gate electrode control means (51) comprise
abnormality detection means (53) comprising a passing current determination circuit (62) capable of determining an abnormality of a passing current value (IC);
a turn-on signal applying circuit (52) for applying a turn-on signal delayed according to the abnormality determination result of said passing current determination circuit (62) to said second insulated gate electrode (G2) through a reversing inverter (22.1); and
a turn-off signal applying circuit (63) for applying a turn-off signal to said first insulated gate electrode (G1) according to the abnormality determination result of said passing current determination circuit (62).

10. The semiconductor apparatus according to claim 1, wherein
said first insulated gate electrode control means (21) comprise timer delay means (31) for delaying a turn-off signal of said input signal (I) for a predetermined period of time and applying the turn-off signal to said first insulated gate electrode (G1);
said second insulated gate electrode control means (51) comprise timer delay means for delaying a turn-on signal of said input signal (I) for a predetermined period of time and a reversing inverter (52) for converting the delayed turn-on signal to a turn-off signal and supplying the turn-off signal to said second insulated gate electrode (G2); and
said control device (80) further comprise abnormality detection and protective means comprising a timer circuit (91) for detecting a rising edge of an operating voltage applied to a collecting electrode (C) of said double gate semiconductor device (15) to operate for a predetermined time, an abnormality notifying circuit (81) for monitoring the first insulated gate electrode potential and the second insulated gate electrode potential during operation of said timer circuit (91) and giving a low potential notify signal when both said insulated gate electrode potentials are low, and a turn-off signal applying circuit (63) for applying a turn-off signal to said first insulated gate electrode control means (21) and said second insulated gate electrode control means (51) in response to said notify signal.

## Patentansprüche

1. Halbleitervorrichtung mit:
einer Doppelgatehalbleitervorrichtung (15) mit einer ersten isolierten Gateelektrode (G1) zum Steuern des Übergangs von einem Transistorzustand in einen EIN/AUS-Betrieb und einer zweiten isolierten Gateelektrode (G2) zum Steuern des Übergangs in einen Thyristorzustand und den Transistorzustand, wobei die erste und zweite isolierte Gateelektrode (G1, G2) zueinander umgekehrte Spannungsanlegebetriebsarten aufweisen; und
einer Steurvorrichtung (20; 50; 60; 70; 80) zum Steuern der Doppelgatehalbleitervorrichtung (15) entsprechend einem einzelnen Eingangssignal; wobei die Steuervorrichtung (20; 50; 60; 70; 80) umfaßt:
eine erste Isolationsgateelektrodensteuervorrichtung (21; 21A) zum Verzögern eines Abschaltsignals des Eingangssignals (I) und zum Zuführen des verzögerten Signals zu der ersten isolierten Gateelelktrode (G1); und eine zweite Isolationsgateelektrodensteuervorrichtung (22; 51; 71) zum Invertieren des Eingangssignals (I) und zum Zuführen des invertierten Signals zu der zweiten isolierten Gateelektrode (G2).

2. Halbeleitervorrichtung nach Anspruch 1, wobei
die erste Isolationsgatesteuervorrichtung (21) ein Zeitgeberverzögerungsvorrichtung (31) umfaßt zum Verzögern eines Abschaltsignals des Eingangssignals (I) für eine vorbestimmte Zeitdauer und zum Anlegen des Signals an die erste isolierte Gateelektrode (G1); und
die zweite Isolationsgateelektrodensteuervorrichtung (22) einen Umkehrinvertierer (22.1) für das Eingangssignal (I) aufweist und eine geradzahlige Anzahl von Signalverlaufsformgebungsinvertierern (23.1, 23.2, 23.3, 23.4), die seriell zu dem Invertierer (22.1) geschaltet sind.

3. Halbleitervorrichtung nach Anspruch 1, wobei
die erste Isolationsgatesteuervorrichtung (21A) eine Operationsbestimmungsverzögerungsvorrichtung (25A) aufweist mit einer Operationsbestimmungsschaltung (41) zum Bestimmen einer an eine Kollektorelektrode (C) der Doppelgatehalbleitervorrichtung (15) angelegten Betriebsspannung, und eine Abschaltsignalanlegeschaltung (24) zum Anlegen eines Abschaltsignals an die erste isolierte Gateelektrode (G1) entsprechend dem Bestimmungsergebnis der Operationsbestimmungsschaltung (41); und
die zweite Isolationsgateelektrodensteuervorrichtung (22) einen Umkehrinvertierer (22.1) des Eingangssignals (I) aufweist und eine geradzahlige Anzahl von Signalverlaufsformgebungsinvertierern (23.1, 23.2, 23.3., 23.4), die seriell zu dem Umkehrinvertierer (22.1) geschaltet sind.

4. Halbleitervorrichtung nach Anspruch 1, wobei
die erste Isolationsgateelektrodensteuervorrichtung (21) eine Zeitgeberverzögerungsvorrichtung (31) aufweist zum Verzögern eines Abschaltsignals des Eingangssignals (I) für eine vorbestimmte Zeitdauer und zum Anlegen des Signals an die erste isolierte Gateelektrode (G1);
die zweite Isolationsgateelektrodensteuervorrichtung (22) einen Umkehrinvertierer (22.1) des Eingangsignals (I) aufweist und eine geradzahlige Anzahl von Signalverlaufsformgebungsinvertieren (23.1, 23.2, 23.3, 23.4), die seriell zu dem Umkehrinvertierer (22.1) geschaltet sind; und
die Steuervorrichtung (60) weiterhin umfaßt eine Abnormalitätserfassungs- und Schutzvorrichtung (61) mit einer Durchlaßstrombestimmungsschaltung (62) zum Bestimmen einer Abnormalität eines Durchlaßstromwerts (IC), und eine Abschaltsignalanlegeschaltung (63) zum Anlegen eines Abschaltsignals an die erste Isolationsgateelektrodensteuervorrichtung (21) im Ansprechen auf das Abnormalitätsbestimmungsergebnis der Durchlaßstrombestimmungsschaltung (62).

5. Halbleitervorrichtung nach Anspruch 4, wobei die zweite Isolationsgateelektrodensteuervorrichtung (51) eine Strombestimmungsschaltung (62) aufweist zum Bestimmen einer Abnormalität eines Durchlaßstromwerts (IC), wobei die zweite Isolationsgateelektrodensteuervorrichtung (51) das Eingangssignal (I) verzögert, das Potential im Ansprechen auf ein Abnormalitätsbestimmungsergebnis des Durchlaßstromwerts (IC) umkehrt, und das Potential an die zweite isolierte Gateelektrode (G2) anlegt.

6. Halbleitervorrichtung nach Anspruch 5, wobei die zweite Isolationsgateelektrodensteuervorrichtung (51) umfaßt eine Umkehreinschaltsignalanlegeschaltung (52) zum Ausgeben eines im Ansprechen auf das Bestimmungsergebnis der Strombestimmungsschaltung (62) verzögerten Einschaltsignals, Invertieren des verzögerten Einschaltsignals und Anlegen des Einschaltsignals an die zweite isolierte Gateelektrode (G2); und eine Abschaltsignalanlegeschaltung (63) zum Anlegen eines Abschaltsignals an die erste isolierte Gateelektrode (G1) entsprechend dem Abnormalitätsbestimmungsergebnis der Strombestimmunsschaltung (62).

7. Halbleitervorrichtung nach Anspruch 6, wobei die Doppelgatehalbleitervorrichtung (15) eine Sensordoppelgatehalbleitervorrichtung mit einem Sensoranschluß (E1) ist; und die Strombestimmungsschaltung (52) mit dem Sensoranschluß (E1) verbunden ist, um eine Abnormalität des Durchlaßstroms (IC) zu bestimmen.

8. Halbleitervorrichtung nach Anspruch 7, wobei die Strombestimmungsschaltung (62) der zweiten Isolationsgateelektrodensteuervorrichtung (51) eine Spannungsbestimmungsschaltung zum Bestimmen einer Abnormalität der an eine Kollektorelektrode (C) der Doppelgatehalbleitervorrichtung (15) angelegten Betriebsspannung ist.

9. Halbleitervorrichtung nach Anspruch 5, wobei die zweite Isolationsgateelektrodensteuervorrichtung (51) umfaßt eine Abnormalitätserfassungsvorrichtung (53) mit einer Durchlaßstrombestimmungsschaltung (62) zum Bestimmen einer Abnormalität eines Durchlaßstromwerts (IC);
eine Einschaltsignalanlegeschaltung (52) zum Anlegen eines entsprechend dem Abnormalitätsbestimmungsergebnis der Durchlaßstrombestimmungsschaltung (62) verzögerten Einschaltsignals an die zweite isolierte Gateelektrode (G2) über einen Umkehrinvertierer (22.1); und
eine Abschaltsignalanlegeschaltung (63) zum Anlegen eines Abschaltsignals an die erste isolierte Gateelektrode (G1) entsprechend dem Abnormalitätsbestimmungsergebnis der Durchlaßstrombestimmungsschaltung (62).

10. Halbleitervorrichtung nach Anspruch 1, wobei
die erste Isolationsgateelektrodensteuervorrichtung (21) eine Zeitgeberverzögerungsvorrichtung (31) aufweist zum Verzögern eines Abschaltsignals des Eingangssignals (I) für eine vorbestimmte Zeitdauer und zum Anlegen des Abschaltsignals an die erste isolierte Gateelektrode (G1);
die zweite Isolationsgateelektrodensteuervorrichtung (51) eine Zeitgeberverzögerungsvorrichtung aufweist zum Verzögern eines Einschaltsignals des Eingangssignals (I) für eine vorbestimmte Zeitdauer und einen Umkehrinvertierer (52) zu Umwandeln des verzögerten Einschaltsignals in ein Abschaltsignal und zum Zuführen des Abschaltsignals zu der zweiten isolierten Gateelektrode (G2); und
die Steuervorrichtung (80) weiterhin umfaßt eine Abnormalitätserfassungs- und Schutzvorrichtung mit einer Zeitgeberschaltung (91) zum Erfassen einer ansteigenden Flanke einer an eine Kollektorelektrode (C) der Doppelgatehalbleitervorrichtung (15) angelegten Betriebsspannung, um für eine vorbestimmte Zeitdauer betrieben zu werden, eine Abnormalitätsmitteilungsschaltung (81) zum Überwachen des Potentials der ersten isolierten Gateelektrode und des Potentials der zweiten isolierten Gateelektrode während des Betriebs der Zeitgeberschaltung (91) und zum Abgeben eines Mitteilungssignals mit niedrigem Potential, wenn beide Potentiale der isolierten Gateelektroden niedrig sind, und eine Abschaltsignalanlegeschaltung (63) zum Anlegen eines Abschaltsignals an die erste Isolationsgateelektrodensteuervorrichtung (21) und die zweite Isolationsgateelektrodensteuervorrichtung (51) im Ansprechen auf das Mitteilungssignal.

## Revendications

1. Dispositif à semi-conducteurs comportant :
un dispositif (15) à semi-conducteurs à double grille ayant une première électrode (G1) de grille isolée capable de commander la transition d'un état de transistor à un état de fonctionnement ouvert ou fermé et une seconde électrode (G2) de grille isolée capable de commander la transition à un état de thyristor et à l'état de transistor, les première et seconde électrodes (G1, G2) de grille isolées ayant des modes d'application de tension inverse l'un à l'autre ; et
un dispositif (20; 50; 60; 70; 80) de commande destiné à commander le dispositif (15) à semi-conducteurs à double grille en fonction d'un signal d'entrée unique ; le dispositif (20; 50; 60; 70; 80) de commande comportant :
des premiers moyens (21; 21A) de commande d'électrode de grille isolée destinés à retarder un signal de passage à l'ouverture du signal (I) d'entrée et à envoyer le signal retardé à la première électrode (G1) de grille isolée; et
des seconds moyens (22; 51; 71) de commande d'électrode de grille isolée destinés à inverser le signal (I) d'entrée et à envoyer le signal inversé à la seconde électrode (G2) de grille isolée.

2. Dispositif à semi-conducteurs suivant la revendication 1, dans lequel
les premiers moyens (21) de commande de grille isolée comportent des moyens (31) de retard de compteur de temps destinés à retarder un signal de passage à l'ouverture du signal (I) d'entrée pendant un temps déterminé à l'avance et à appliquer le signal à la première électrode (G1) de grille isolée; et
les seconds moyens (22) de commande d'électrode de grille isolée comportent un inverseur (22.1) inversant pour le signal (I) d'entrée et un nombre pair d'inverseurs (23.1, 23.2, 23.3, 23.4) formant formes d'onde reliés en série à l'inverseur (22.1).

3. Dispositif à semi-conducteurs suivant la revendication 1, dans lequel
les premiers moyens (21A) de commande de grille isolée comportent des moyens (25A) de retard de détermination de fonctionnement comportant un circuit (41) de détermination de fonctionnement pour déterminer une tension de fonctionnement appliquée à une électrode (C) collectrice du dispositif (15) à semi-conducteurs à double grille, et un circuit (24) d'application de signal de passage à l'ouverture destiné à appliquer un signal de passage à l'ouverture à la première électrode (G1) de grille isolée suivant le résultat de détermination du circuit (41) de détermination de fonctionnement; et
les seconds moyens (22) de commande d'électrode de grille isolée comportent un inverseur (22.1) inversant du signal (I) d'entrée et un nombre pair d'inverseurs (23.1, 23.2, 23.3, 23.4) formant formes d'onde reliés en série à l'inverseur (22.1) inversant.

4. Dispositif à semi-conducteurs suivant la revendication 1, dans lequel
les premiers moyens (21) de commande d'électrode de grille isolée comportent des moyens (31) de retard de compteur de temps destinés à retarder un signal de passage à l'ouverture du signal (I) d'entrée pour une période de temps déterminée à l'avance et à appliquer le signal à la première électrode (G1) de grille isolée;
les seconds moyens (22) de commande d'électrode de grille isolée comportent un inverseur (22.1) inversant du signal (I) d'entrée et un nombre pair d'inverseurs (23.1, 23.2, 23.3, 23.4) formant forme d'onde reliés en série à l'inverseur (22.1) inversant ; et
le dispositif (60) de commande comporte en outre des moyens (61) de protection et de détection d'anomalies comportant un circuit (62) de détermination de courant passant capable de déterminer une anomalie d'une valeur (IC) de courant passant, et un circuit (63) d'application de signal de passage à l'ouverture destiné à appliquer un signal de passage à l'ouverture aux premiers moyens (21) de commande d'électrode de grille isolée en réponse au résultat de la détermination d'anomalies du circuit (62) de détermination de courant passant.

5. Dispositif à semi-conducteurs suivant la revendication 4, dans lequel les seconds moyens (51) de commande d'électrode de grille isolée comportent un circuit (62) de détermination de courant capable de déterminer une anomalie d'une valeur (IC) de courant passant, les seconds moyens (51) de commande d'électrode de grille isolée retardant le signal (I) d'entrée, inversant le potentiel en réponse à un résultat de détermination d'anomalies de la valeur (IC) de courant passant, et appliquant le potentiel à la seconde électrode (G2) de grille isolée.

6. Dispositif à semi-conducteurs suivant la revendication 5, dans lequel les seconds moyens (51) de commande d'électrode de grille isolée comportent,
un circuit (52) d'application de signal de passage à la fermeture inversée destiné à émettre en sortie un signal de passage à la fermeture retardé en réponse au résultat de la détermination du circuit (62) de détermination de courant, à inverser le signal de passage à la fermeture retardé et à appliquer le signal de passage à la fermeture à la seconde électrode (G2) de grille isolée ; et
un circuit (63) d'application de signal de passage à l'ouverture destiné à appliquer un signal de passage à l'ouverture à la première électrode (G1) de grille isolée en fonction du résultat de la détermination d'anomalies du circuit (62) de détermination de courant.

7. Dispositif à semi-conducteurs suivant la revendication 6, dans lequel le dispositif (15) à semi-conducteurs à double grille est un dispositif à semi-conducteurs à double grille de détection ayant une borne (E1) de détection; et
le circuit (52) de détermination de courant capable de déterminer une anomalie du courant (IC) passant est relié à la borne (E1) de détection.

8. Dispositif à semi-conducteurs suivant la revendication 7, dans lequel le circuit (62) de détermination de courant des seconds moyens (51) de commande d'électrode de grille isolée est un circuit de détermination de tension capable de déterminer une anomalie de la tension de fonctionnement appliquée à une électrode (C) collectrice du dispositif (15) à semi-conducteurs à double grille.

9. Dispositif à semi-conducteurs suivant la revendication 5, dans lequel les seconds moyens (51) de commande d'électrode de grille isolée comportent
des moyens (53) de détection d'anomalies comportant un circuit (62) de détermination de courant passant capable de déterminer une anomalie d'une valeur (IC) de courant passant ;
un circuit (52) d'application de signal de passage à la fermeture destiné à appliquer un signal de passage à la fermeture retardé en fonction du résultat de détermination d'anomalies du circuit (62) de détermination de courant passant à la seconde électrode (G2) de grille isolée par un inverseur (22.1) inversant ; et
un circuit (63) d'application de signal de passage à l'ouverture destiné à appliquer un signal de passage à l'ouverture à la première électrode (G1) de grille isolée en fonction du résultat de détermination d'anomalies du circuit (62) de détermination de courant passant.

10. Dispositif à semi-conducteurs suivant la revendication 1, dans lequel
les premiers moyens (21) de commande d'électrode de grille isolée comportent des moyens (31) de retard de compteur de temps destinés à retarder un signal de passage à l'ouverture du signal (I) d'entrée pour une période de temps déterminée à l'avance et à appliquer le signal de passage à l'ouverture à la première électrode (G1) de grille isolée ;
les seconds moyens de commande d'électrode de grille isolée comportent des moyens de retard de compteur de temps destinés à retarder un signal de passage à la fermeture du signal (I) d'entrée pour une période de temps déterminée à l'avance et un inverseur (52) inversant destiné à convertir le signal de passage à la fermeture retardé en un signal de passage à l'ouverture et à envoyer le signal de passage à l'ouverture à la seconde électrode (G2) de grille isolée ; et
le dispositif (80) de commande comporte en outre des moyens de protection et de détection d'anomalies comportant un circuit (91) compteur de temps destiné à détecter un front montant d'une tension de fonctionnement appliquée à une électrode (C) collectrice du dispositif (15) à semi-conducteurs à double grille pour fonctionner pendant un temps déterminé à l'avance, un circuit (81) de notification d'anomalies destiné à surveiller le potentiel de la première électrode de grille isolée et le potentiel de la seconde électrode de grille isolée pendant le fonctionnement du circuit (91) compteur de temps et à donner un signal de notification de potentiel bas, lorsque les deux potentiels d'électrode de grille isolée sont bas,
et un circuit (63) d'application de signal de passage à l'ouverture destiné à appliquer un signal de passage à l'ouverture aux premiers moyens (21) de commande d'électrode de grille isolée et aux seconds moyens (51) de commande d'électrode de grille isolée en réponse au signal de notification.
